# EUROPÄISCHE PATENTSCHRIFT

(11) **EP 0 588 026 B1**
(45) Veröffentlichungstag und Bekanntmachung des Hinweises auf die Patenterteilung: **03.12.1997**
(21) Anmeldenummer: 93111801.2
(22) Anmeldetag: 23.07.1993
(51) Int. Cl.: H01L 29/74, H01L 29/41, H01L 23/051

(54) **Abschaltbares Hochleistungs-Halbleiterbauelement**
Turn-off high-power semiconductor device
Dispositif semiconducteur de haute puissance à commande d'extinction

(30) Priorität: 15.08.1992 DE 4227063
(43) Veröffentlichungstag der Anmeldung: 23.03.1994
(73) Patentinhaber: ABB RESEARCH LTD., 8050 Zürich (CH)
(72) Erfinder: Grüning, Horst, Dr., D-5432 Wettingen (CH)
(74) Vertreter: Hetzer, Hans Jürgen

(56) Entgegenhaltungen:
- EP-A- 0 328 778
- EP-A- 0 381 849
- EP-A- 0 428 044
- EP-A- 0 432 796
- EP-A- 0 476 661
- DE-A- 2 049 571
- FR-A- 2 313 774

## Beschreibung

### TECHNISCHES GEBIET

Die vorliegende Erfindung bezieht sich auf das Gebiet der Leistungselektronik. Sie betrifft ein abschaltbares Hochleistungs-Halbleiterbauelement, insbesondere in Form eines GTO, nach dem Oberbegriff des ersten Anspruchs.

### STAND DER TECHNIK

Ein solches Bauelement ist z.B. aus der Druckschrift EP-B1-0 159 797 (Fig. 7) bekannt. Diese Schrift offenbart eine Halbleitervorrichtung mit einem im wesentlichen ringförmigen Gatekontakt, welcher über eine drahtförmge Gatezuführung aus dem Gehäuse herausgeführt ist. Ein ähnliches Gehäuse ist aus der EP-A3-0 432 796 und der FR-A-2 313 774 bekannt.

In der Leistungselektronik geht die Entwicklung zu immer leistungsfähigeren und immer schnelleren abschaltbaren Bauelementen, um beispielsweise in Umrichtern oder Antrieben elektrische Leistungen mit steigendem Wirkungsgrad umsetzen zu können. Bei solchen Bauelementen handelt es sich beispielsweise um die bekannten GTOs, IGBTs oder auch feldgesteuerte Thyristoren (FCThs) bzw. Statische Induktions-Thyristoren (SIThs).

Besondere Schwierigkeiten bereitet dabei die Ansteuerung gerade auch von GTOs, weil bei diesen Bauelementen durch inhomogenes Ein- bzw. Ausschalten kritische Zustände eingenommen werden können, die im Stand der Technik üblicherweise durch eine aufwendige externe Beschaltung, die sogenannten "Snubber", vermieden werden müssen. Derartige "Snubber" verteuern jedoch nicht nur die Schaltung, sondern beanspruchen auch erheblichen Platz und verursachen einen zusätzlichen Leistungsverlust.

Es ist deshalb in jüngster Zeit vorgeschlagen worden (EP-A1-0 489 945), den Beschaltungaufwand bei GTOs dadurch zu verringern, dass man die vorgegebenen Bauelemente mittels einer speziell ausgelegten Gate-Unit "hart" ansteuert, d.h. mit sehr steilen und hohen Gatepulsen für das Ein- und Ausschalten versorgt. Ziel dieser Vorschläge war es, möglichst ohne Modifikationen des GTO selbst und seines Gehäuses auszukommen, so dass die bisherigen, auf dem Markt befindlichen Bauelemente, wie sie in der eingangs genannten Druckschrift beschrieben sind, auch weiterhin einsetzbar blieben.

Obgleich auf diese Weise bereits erhebliche Verbesserungen beim Einsatz von GTOs erzielt werden konnten, lassen sich weitere Vorteile insbesondere dann erreichen, wenn auch Eingriffe in den inneren Aufbau der Bauelemente selbst zugelassen werden. In diesem Zusammenhang ist vor allem die Koppelinduktivität zwischen dem GTO und seiner Gate-Unit von Bedeutung, die bei zu hohen Werten, wie sie durch das herkömmliche Herausführen der Gatezuführung durch das Isoliergehäuse hervorgerufen werden, die "harte" Ansteuerung massgeblich behindert und aufwendige Gate-Units notwendig macht. Zur Vereinfachung der Gate-Unit sowie zur Verringerung ihres Volumens und Stromverbrauchs wird deshalb eine drastische Reduktion der Koppelinduktivität zwischen GTO und Gate-Unit von den bisherigen etwa 30 nH auf Werte <= 2 nH angestrebt.

Insbesondere für FCThs, aber auch für GTOs, sind bereits Lösungen zur Verringerung der Koppelinduktivität vorgeschlagen worden, bei denen der Einbau der wichtigsten Komponenten der Gate-Unit direkt in das Bauelement-Gehäuse vorgesehen ist (siehe dazu: EP-A1-0 328 778 oder EP-A1-0 381 849). Solch ein Einbau führt zwar zu sehr niedrigen Verbindungsinduktivitäten, doch er bringt neben hohen Entwicklungs- und Fertigungskosten auch eine Reihe von Hindernissen mit sich wie:
- die mangelnde Verfügbarkeit geeigneter Pulskondensatoren, die auch unter den hohen Temperaturen die nötigen Kapazitätswerte und die erforderliche Zuverlässigkeit bieten;
- mangelnde Zuverlässigkeit der internen Kontaktierung im Bauelement;
- die Notwendigkeit, die Ansteuerschaltung zum Schutz vor Einkopplungen aus dem Hauptkreis abzuschirmen; und
- die Notwendigkeit, bei Verwendung von GTOs zusätzlich zum Abschaltkreis noch einen Einschaltkreis (eventuell im Gehäuse) und einen Haltekreis zur Erzeugung eines dauerhaften Gatestroms im ON-Zustand anschliessen zu müssen, wobei der Haltekreis wegen der notwendigen Ströme kaum noch im Gehäuse Platz fände.

Aus den genannten Gründen müsste bei der bekannten Lösung ein Teil der Gate-Unit weiterhin ausserhalb des GTO-Gehäuses angeordnet sein.

### DARSTELLUNG DER ERFINDUNG

Es ist daher Aufgabe der Erfindung, ein Hochleistungs-Halbleiterbauelement so zu modifizieren, dass mit einem Minimum an Veränderungen gegenüber herkömmlichen Bauelementen eine Verbindung zur Gate-Unit herstellbar ist, welche die angestrebte niedrige Koppelinduktivität aufweist. Die Gate-Unit könnte dann in bekannter Weise mit bereits erprobten Bauelementen (MOSFETs und Kondensatoren) bestückt werden und wäre zum Service oder dgl. weiterhin so zugänglich wie bisher, ohne dass auf die bekannten Vorteile der "harten" Ansteuerung verzichtet werden müsste.

Die Aufgabe wird bei einem Bauelement der eingangs genannten Art durch die Merkmale des ersten Anspruchs gelöst.

Der Kern der Erfindung besteht also darin, die durch die geometrische Anordnung der einzelnen Elemente im Gate-Kathodenkreis gebildete Schleifeninduktivität durch eine geänderte Ausbildung und Anordnung von Gatekontakt und Gatezuführung zu verringern, indem insbesondere die Gatezuführung näher an den Kathodenkontakt herangebracht wird. Der Gatekontakt wird ringförmig ausgebildet und ist konzentrisch zum Kathodenkontakt angeordnet.

Diese Lösung eignet sich besonders für GTOs, bringt aber auch Vorteile für andere abschaltbare Hochleistungs-Halbleiterbauelemente wie z.B. FCThs, IGBTs oder SITHs.

Dadurch, dass der Gatekontakt ringförmig ausgebildet ist und die Gatezuführung ebenfalls ringförmig ausgebildet und aus dem Bauelement herausgeführt ist, wird eine gute und gleichmässige Verteilung des Gatestroms bei gleichzeitig starker Reduktion der Schleifeninduktivität erzielt.

Eine erste Weiterbildung ist dadurch gekennzeichnet, dass der Gatekontakt den Kathodenkontakt in einem Abstand konzentrisch umgibt, dass die Gatezuführung zwischen dem Kathodenkontakt und dem Isoliergehäuse aus dem Bauelement herausgeführt wird, dass die Gatezuführung den Gatekontakt direkt mit dem ersten Deckel verbindet, und dass der erste Deckel von dem Kathodenkontakt durch einen dazwischenliegenden, den Kathodenkontakt konzentrisch umgebenden Isolierring elektrisch isoliert ist. Dies hat den besonderen Vorteil, dass Isoliergehäuse und Kathodenkontakt, und damit auch die Einspanntechnik für das Bauelement, vom herkömmlichen "Press Pack"-Gehäuse weitgehend beibehalten werden können, und der zwischen Kathodenkontakt und Isoliergehäuse vorhandene Platz optimal genutzt wird.

Eine zweite Weiterbildung ist dadurch gekennzeichnet, dass zur Bereitstellung eines Gateanschlusses und eines Kathodenanschlusses ein Bandleiter vorgesehen ist, welcher aus einer auf beiden Seiten mit einer Metallisierung versehenen Isolierfolie besteht, dass der Bandleiter das Bauelement kathodenseitig überdeckt, wobei die zweite Metallisierung dem Bauelement zugewandt ist, dass im Bereich des Kathodenkontakts von dem Bandleiter die Isolierfolie und die zweite Metallisierung entfernt sind, derart, dass die erste Metallisierung in direktem Kontakt mit dem Kathodenkontakt steht und den Kathodenanschluss bildet, und dass die zweite Metallisierung mit dem ersten Deckel direkt elektrisch verbunden ist und den Gateanschluss bildet.

Diese Art des Aussenanschlusses mittels eines Bandleiters ist besonders induktionsarm und führt in Kombination mit der inneren Gestaltung des Bauelements zu einer Konfiguration, die wegen der geringen Gesamtinduktivität für eine "harte" Ansteuerung besonders geeignet ist.

Gemäss einer zweiten bevorzugten Ausführungsform des erfindungsgemässen Bauelements ist der Gatekontakt ringförmig ausgebildet, ist die Gatezuführung ebenfalls ringförmig ausgebildet und aus dem Bauelement herausgeführt, umgibt der Gatekontakt den Kathodenkontakt in einem Abstand konzentrisch, und ist das Isoliergehäuse in einen oberen Gehäuseteil und einen unteren Gehäuseteil unterteilt und die Gatezuführung zwischen dem oberen und unteren Gehäuseteil aus dem Bauelement herausgeführt. Diese Ausführungsform hat den Vorteil, dass die Kathodenseite des Bauelements bei reduzierter Schleifeninduktivität vollkommen unverändert bleiben kann.

Weitere Ausführungsformen ergeben sich aus den Unteransprüchen.

### KURZE ERLÄUTERUNG DER FIGUREN

Die Erfindung soll nachfolgend anhand von Ausführungsbeispielen im Zusammenhang mit den Figuren näher erläutert werden. Es zeigen
- Fig. 1: im Schnitt ein erstes bevorzugtes Ausführungsbeispiel für ein Bauelement nach der Erfindung mit ringförmigem Gatekontakt und einer zwischen Isoliergehäuse und Kathodenkontakt herausgeführten, ringförmigen Gatezuführung;
- Fig. 2: das Bauelement nach Fig. 1 mit einer Zuleitung des Gate-Kathodenkreises in Form eines Bandleiters;
- Fig. 3: im Schnitt ein zweites bevorzugtes Ausführungsbeispiel für ein Bauelement nach der Erfindung mit ringförmigem Gatekontakt und einer durch das Isoliergehäuse seitlich herausgeführten, ringförmigen Gatezuführung;
- Fig. 4: im Schnitt ein drittes bevorzugtes Ausführungsbeispiel für ein Bauelement nach der Erfindung mit einem ringförmigen Gatekontakt und einer durch den Kathodenkontakt nach oben herausgeführten, ringförmigen Gatezuführung; und
- Fig. 5: im Schnitt ein Beispiel für ein Bauelement wichtig für das Verständnis der Erfindung mit einem zentralen Gatekontakt und einer durch den Kathodenkontakt nach oben herausgeführten, zentralen Gatezuführung.

### WEGE ZUR AUSFÜHRUNG DER ERFINDUNG

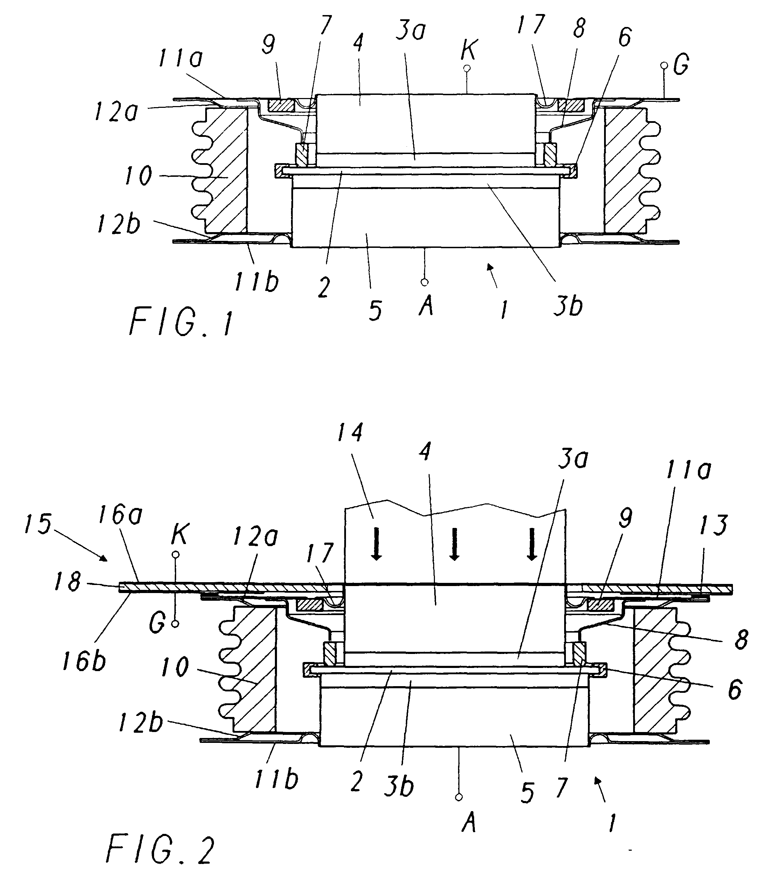

In Fig. 1 ist im Schnitt ein bevorzugtes Ausführungsbeispiel für ein Bauelement nach der Erfindung wiedergegeben. Das Bauelement 1 weist hinsichtlich seines Gehäuses dabei viele Merkmale auf, die bereits vom in der Technik eingeführten "Press Pack"-Gehäuse her bekannt sind. Zentraler Bestandteil des Bauelements ist ein von beiden Seiten mit Druck beaufschlagbarer Stapel von verschiedenen (runden) Scheiben, der in dieser Weise an sich bekannt ist (die einzelnen Scheiben sind in der Figur der Uebersichtlichkeit halber nicht schraffiert).

Der Stapel umfasst ein in der Mitte angeordnetes Halbleitersubstrat 2, welches üblicherweise aus Si gefertigt ist und den eigentlichen aktiven Teil des Bauelements (beim GTO beispielsweise die Einzelthyristoren, die umgebende Gatemetallisierung, Shorts etc.) enthält. Zur Erhöhung der Spannungsfestigkeit ist das Halbleitersubstrat mit einer Randpassivierung 6 versehen. Das Halbleitersubstrat 2 wird kathodenseitig von einem scheibenförmigen Kathodenkontakt 4 und anodenseitig von einem ebenfalls scheibenförmigen Anodenkontakt 5, die beide üblicherweise aus Cu bestehen, kontaktiert. Ueber den Kathodenkontakt 4 erfolgt der Kathodenanschluss K, über den Anodenkontakt 5 der Anodenanschluss A. Zur Verbesserung des Wechsellastverhaltens können zwischen Halbleitersubstrat 2 und den Kontakten 4 und 5 Mo-Scheiben 3a,b vorgesehen sein, welche den Unterschied in der thermischen Ausdehnung zwischen Si und Cu ausgleichen. Das Halbleitersubstrat kann dabei entweder mit einer der Mo-Scheiben 3a,b stoffschlüssig verbunden oder zwischen den Scheiben nur durch Druck gehalten sein (sog. "free floating silicon"-Technik bzw. "direkter Druckkontakt").

Der Stapel aus den Scheiben 2, 3a, 3b, 4 und 5 ist konzentrisch in einem ringförmigen Isoliergehäuse 10 angeordnet, welches vorzugsweise aus einer Keramik besteht und auf der Aussenseite zur Erhöhung der Spannungsfestigkeit mit umlaufenden Rillen versehen ist. Das Isoliergehäuse 10 ist an beiden Enden jeweils mit einem Flansch 12a,b ausgestattet, der als Blechring ausgebildet und mit der Keramik des Gehäuses durch eine Metall-Keramik-Verbindung verbunden ist. Mit den Flanschen 12a,b, stoffschlüssig verbunden (verlötet, verschweisst o.ä.) sind ein erster und zweiter Deckel 11a bzw. 11b, die ebenfalls ringförmig sind und aus einem Blech bestehen. Der zweite Deckel 11b ist anodenseitig an seinem Innenrand mit dem Anodenkontakt 5 verbunden und bildet zusammen mit dem Anodenkontakt auf dieser Seite des Gehäuses einen hermetischen (gasdichten), vertikal geringfügig auslenkbaren Gehäuseabschluss. Die anodenseitige Konfiguration entspricht damit dem bekannten "Press Pack"-Gehäuse.

Auf der Kathodenseite weicht die Konfiguration dagegen vom herkömmlichen Gehäuse ab: Der erste Deckel 11a ist zwar an seinem Aussenrand ebenfalls mit dem zugehörigen ersten Flansch 12a stoffschlüssig verbunden. Sein Innenrand reicht jedoch nicht bis zum Kathodenkontakt 4, sondern endet an einem Isolierring 9, der vorzugsweise aus einer Keramik besteht und zwischen Kathodenkontakt 4 und erstem Flansch 11a konzentrisch angeordnet ist. Der Isolierring 9 selbst ist dann mit dem Kathodenkontakt 4 durch einen weiteren Verbindungsring 17 aus Blech verbunden. Kathodenkontakt 4, Verbindungsring 17, Isolierring 9, erster Deckel 11a und erster Flansch 12a bilden so den kathodenseitigen hermetischen Abschluss des Gehäuses.

Der Isolierring 9 isoliert den ersten Deckel 11a elektrisch vom Kathodenkontakt 4. Damit wird die Möglichkeit geschaffen, den ersten Deckel 11a als Gateanschluss G zu verwenden. Dazu wird das Halbleitersubstrat 2 so ausgelegt, dass der Zugriff auf das Gate durch einen ringförmigen Gatekontakt 7 erfolgen kann, der den Kathodenkontakt 4 bzw. die erste Mo-Scheibe 3a konzentrisch umgibt. Der Gatekontakt 7 ist über eine ebenfalls ringförmige Gatezuführung 8 mit dem ersten Deckel 11a elektrisch leitend verbunden. Die Gatezuführung 8 ist vorzugsweise aus Blech hergestellt und so gestaltet, dass sie parallel zum und möglichst nahe am Kathodenkontakt 4 nach oben führt und dort - beispielsweise durch eine Kaltschweissung - mit der Innenseite des ersten Deckels 11a fest verbunden ist. Da der Gatekontakt 7 bevorzugt ein Druckkontakt ist, ist die Gatezuführung 8 federnd ausgelegt, um den notwendigen Anpressdruck für den Gatekontakt 7 zu erzeugen. Man erkennt an der Darstellung in Fig. 1 deutlich, dass diese Art der induktionsarmen Zuleitungsgeometrie nach aussen hin praktisch nicht in Erscheinung tritt (mit der Ausnahme, dass der erste Deckel 11a nicht länger mit dem Kathodenkontakt 4 auf gleichem Potential liegt, sondern einen eigenständigen Gateanschluss G bildet), so dass Gehäusegeometrie und Abmessungen praktisch unverändert beibehalten werden können.

Führt man nun in einer Weiterbildung der Erfindung den Rand des Gehäuses, d.h. insbesondere, den ersten Deckel 11a so aus, dass eine Lötung möglich wird, kann das Bauelement kathodenseitig direkt an einen extrem induktionsarmen Bandleiter 15 angeschlossen werden (Fig. 2). Ein solcher Bandleiter 15 besteht aus einer ausreichend dicken Isolierfolie 18, insbesondere aus einem Polyimid, die beidseitig mit einer Metallisierung 16a bzw. 16b, vorzugsweise aus Cu, versehen ist. Der Bandleiter 15 bedeckt ganzflächig die Kathodenseite des Bauelements 1 und kommt somit auch zwischen dem Kathodenkontakt 4 und dem auf den Kathodenkontakt 4 (in Pfeilrichtung) drückenden Kathodenstempel 14 zu liegen. Um Schwierigkeiten mit der Isolierfolie 18 im Bereich des Kathodenkontakts 4 zu vermeiden, werden die Isolierfolie und die zweite Metallisierung 16b in diesem Bereich entfernt. Auf diese Weise liegt nur die erste (obere) Metallisierung 16a zwischen Kathodenkontakt 4 und Kathodenstempel 14 und wird als Kathodenanschluss K verwendet. Die zweite (untere) Metallisierung 16b wird mittels einer Lötverbindung 13 mit dem ersten Deckel 11a elektrisch leitend verbunden und als Gateanschluss G verwendet.

Beide Massnahmen, die Umgestaltung der im Gehäuse liegenden Gatezuführung 8 und der Einsatz eines Bandleiters, ermöglichen eine extrem induktionsarme Verbindung zwischen dem Bauelement 1 und der zugehörigen Gate-Unit, so dass eine "harte" Ansteuerung nunmehr mit wesentlich geringerem Schaltungsaufwand realisiert werden kann.

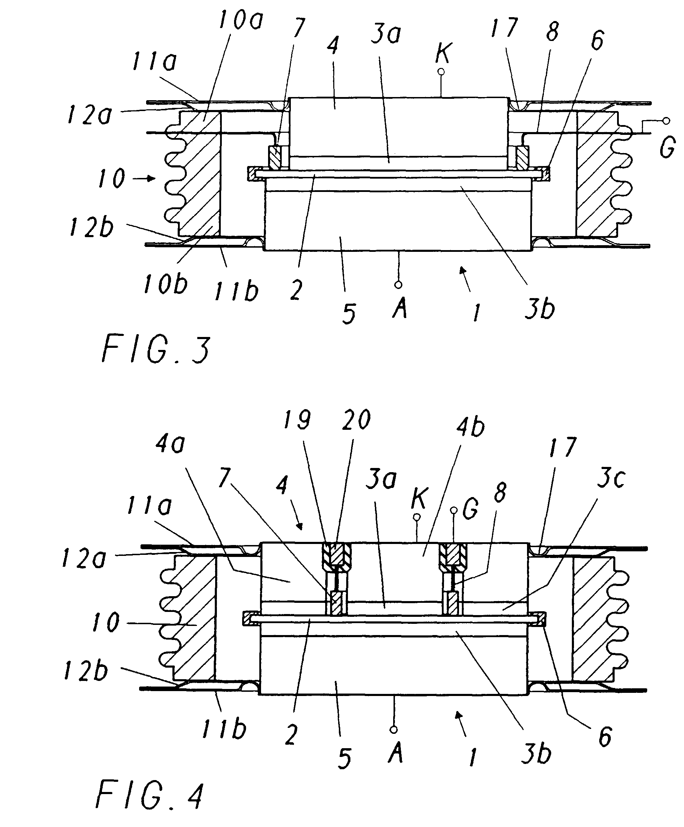

Ein zweites bevorzugtes Ausführungsbeispiel ist in der Fig. 3 dargestellt. Der Aufbau ähnelt dem Bauelement der Fig. 1, mit dem Unterschied, dass das herkömmliche "Press Pack"-Gehäuse mit noch weniger Aenderungen übernommen werden kann. Der Gatekontakt 7 ist auch in diesem Fall ringförmig ausgebildet und umgibt konzentrisch den Kathodenkontakt 4. Die ringförmige Gatezuführung 8 wird hier nun nicht zwischen Isoliergehäuse 10 und Kathodenkontakt 4 aus dem Bauelement 1 herausgeführt, sondern seitlich durch das Isoliergehäuse 10. Dazu ist das Isoliergehäuse 10 in einen oberen und unteren (ringförmigen) Gehäuseteil 10a bzw. 10b unterteilt, zwischen denen die Gatezuführung 8 zu liegen kommt. Die notwendige hermetische Verbindung zwischen Gatezuführung 8 und den Gehäuseteilen 10a,b kann beispielsweise durch eine direkte Metall-Keramik-Verbindung oder durch den Einsatz von beiderseitigen Flanschen, ähnlich den Flanschen 12a und 12b, erzielt werden. Der Gateanschluss G kann dann - wie beim herkömmlichen Bauelement - seitlich erfolgen.

Ein drittes bevorzugtes Ausführungsbeispiel zeigt die Fig. 4. Der Gatekontakt 7 ist hier ebenfalls ringförmig ausgestaltet, jedoch mit einem gegenüber Fig. 1 und 3 reduzierten Durchmesser. Durch diese an sich bekannte Art der Gatekontaktierung kann der Gatestrom gleichmässiger an die über das ganze Halbleitersubstrat 2 verteilten Elementarthyristoren herangeführt werden. Der Gatekontakt 7 ist mittels der darüberliegenden, ringförmigen Gatezuführung 8 und einen daran anschliessenden Anschlussring 20 durch den Kathodenkontakt 4 von der Kathodenseite her elektrisch zugänglich. Das ringförmige Gebilde aus Gatekontakt 7, Gatezuführung 8 und Anschlussring 20 ist in einem Ringspalt im Kathodenkontakt 4 isoliert untergebracht. Dieser Ringspalt entsteht dadurch, dass sowohl die obere Mo-Zwischenlage aus einer inneren Mo-Scheibe 3a und einem konzentrischen äusseren Mo-Ring 3c, als auch der Kathodenkontakt 4 aus einer inneren Kontaktscheibe 4b und einem äusseren, konzentrischen Kontaktring 4a zusammengesetzt ist. Zur mechanischen Fixierung ist der Anschlussring 20 in eine Isoliermasse 19 eingebettet, die zumindest den oberen Teil des Ringspalts ausfüllt und z.B. aus Glas oder einem Kunststoff bestehen kann.

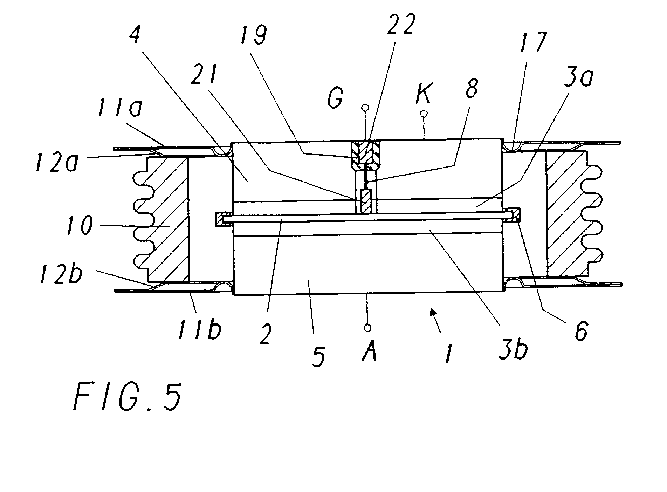

Ein viertes Bauelement ist schliesslich in Fig. 5 dargestellt. Hier ist in einem Durchgangsloch, welches durch die obere Mo-Scheibe 3a und den Kathodenkontakt 4 in axialer Richtung nach aussen führt, ein zentraler Gatekontakt 21 angeordnet, der über eine zentrale Gatezuführung 8 mit einem ebenfalls in Isoliermasse 19 eingebetteten Zentralanschluss 22 verbunden ist. Die Gatezuführung 8 kann hier, wie in allen Ausführungsbeispielen, federnd ausgeführt sein, um einen Anpressdruck für den Gatekontakt zu erzeugen.

Bei dem Bauelement der Fig. 5 ist allerdings zu berücksichtigen, dass der hohe Gate-Spitzenstrom in diesem Fall durch kleine Leitungsquerschnitte von innen nach aussen verteilt werden muss und dass zum Anschluss des Gates ein Bandleiter 15 mit der zweiten Metallisierung 16b bis in den Zentralbereich des Kathodenkontakts 4 geführt werden muss mit der Gefahr eines schlechten Wärmeübergangs und eines Herausdrückens der Isolierfolie 18 bei Druckbelastung.

Insgesamt ergibt sich mit der Erfindung ein abschaltbares Hochleistungs-Halbleiterbauelement, welches durch eine induktionsarme Auslegung im Inneren und gegebenenfalls durch eine induktionsarme Zuleitung auf besonders einfache Weise "hart" angesteuert werden kann.

### BEZEICHNUNGSLISTE

- 1: Bauelement
- 2: Halbleitersubstrat
- 3a,b: Mo-Scheibe
- 3c: Mo-Ring
- 4: Kathodenkontakt
- 4a: äusserer Kontaktring
- 4b: innere Kontaktscheibe
- 5: Anodenkontakt
- 6: Randpassivierung
- 7: Gatekontakt (ringförmig)
- 8: Gatezuführung
- 9: Isolierring
- 10: Isoliergehäuse
- 10a: oberer Gehäuseteil
- 10b: unterer Gehäuseteil
- 11a,b: Deckel
- 12a,b: Flansch
- 13: Lötverbindung
- 14: Kathodenstempel
- 15: Bandleiter
- 16a,b: Metallisierung
- 17: Verbindungsring
- 18: Isolierfolie
- 19: Isoliermasse
- 20: Anschlussring
- 21: Gatekontakt (zentral)
- 22: Zentralanschluss
- A: Anodenanschluss
- G: Gateanschluss
- K: Kathodenanschluss

## Patentansprüche

1. Abschaltbares Hochleistungs-Halbleiterbauelement, insbesondere in Form eines GTO, mit einem scheibenförmigen Halbleitersubstrat (2), welches konzentrisch in einem ringförmigen Isoliergehäuse (10) zwischen einem mit Druck beaufschlagbaren, scheibenförmigen Kathodenkontakt (4) und einem ebenfalls mit Druck beaufschlagbaren, scheibenförmigen Anodenkontakt (5) angeordnet ist und auf der Seite des Kathodenkontakts durch einen ringförmig ausgebildeten Gatekontakt (7, 21) kontaktiert wird, wobei der Kathodenkontakt (4) über einen ersten Deckel (1la) mit dem einen Ende des Isoliergehäuses (10) und der Anodenkontakt (5) über einen zweiten Deckel (11b) mit dem anderen Ende des Isoliergehäuses (10) verbunden ist und ein nach aussen hermetisch abgeschlossenes Bauelement (1) bilden, und wobei der Gatekontakt (7) über eine nach aussen geführte, Gatezuführung (8) mit einem Gatestrom beaufschlagbar ist, wobei der Gatekontakt (7) den Kathodenkontakt (4) in einem Abstand konzentrische umgibt;
dadurch gekennzeichnet, dass
(a) die Gatezuführung (8) ebenfalls ringförmig ausgebildet und zum Kathodenkontakt (4) konzentrisch angeordnet ist;
(b) die Gatezuführung (8) vom Kathodenkontakt (4) durch einen einzigen Isolator elektrisch getrennt ist.

2. Bauelement nach Anspruch 1, dadurch gekennzeichnet, dass
(a) die Gatezuführung (8) zwischen dem Kathodenkontakt (4) und dem Isoliergehäuse (10) aus dem Bauelement (1) herausgeführt ist,
(b) die Gatezuführung (8) den Gatekontakt (7) direkt mit dem ersten Deckel (11a) verbindet,
(c) und der erste Deckel (11a) von dem Kathodenkontakt (4) durch einen dazwischenliegenden, den Kathodenkontakt (4) konzentrisch umgebenden Isolierring (9) elektrisch isoliert ist.

3. Bauelement nach Anspruch 2, dadurch gekennzeichnet, dass der Isolierring (9) aus einer Keramik besteht.

4. Bauelement nach Anspruch 2, dadurch gekennzeichnet, dass der Isolierring (9) und der Kathodenkontakt (4) über einen metallischen Verbindungsring (17) miteinander verbunden sind.

5. Bauelement nach Anspruch 2, dadurch gekennzeichnet, dass die beiden Deckel (11a,b) und die Gatezuführung (8) aus einem Blech bestehen und die Gatezuführung (8) mit dem ersten Deckel (11a) auf dessen Innenseite mittels einer Kaltschweissung verbunden sind.

6. Bauelement nach Anspruch 5, dadurch gekennzeichnet, dass
(a) zur Bereitstellung eines Gateanschlusses (G) und eines Kathodenanschlusses (K) ein Bandleiter (15) vorgesehen ist, welcher aus einer auf beiden Seiten mit einer Metallisierung (16a,b) versehenen Isolierfolie (18) besteht;
(b) der Bandleiter (15) das Bauelement (1) kathodenseitig überdeckt, wobei die zweite Metallisierung (16b) dem Bauelement (1) zugewandt ist;
(c) im Bereich des Kathodenkontakts (4) von dem Bandleiter (15) die Isolierfolie (18) und die zweite Metallisierung (16b) entfernt sind, derart, dass die erste Metallisierung (16a) in direktem Kontakt mit dem Kathodenkontakt (4) steht und den Kathodenanschluss (K) bildet; und
(d) die zweite Metallisierung (16b) mit dem ersten Deckel (11a) direkt elektrisch verbunden ist und den Gateanschluss (G) bildet.

7. Bauelement nach Anspruch 6, dadurch gekennzeichnet, dass die Isolierfolie (18) des Bandleiters (15) aus einem Polyimid und die beiden Metallisierungen (16a,b) aus Cu bestehen, und dass die zweite Metallisierung (16b) mit dem ersten Deckel (11a) verlötet ist.

8. Bauelement nach Anspruch 1, dadurch gekennzeichnet, dass das Isoliergehäuse (10) in einen oberen Gehäuseteil (10a) und einen unteren Gehäuseteil (10b) unterteilt ist, und die Gatezuführung (8) zwischen dem oberen und unteren Gehäuseteil (10a bzw. 10b) aus dem Bauelement (1) herausgeführt ist.

9. Bauelement nach Anspruch 1, dadurch gekennzeichnet, dass
(a) der Kathodenkontakt (4) unterteilt ist in eine innere Kontaktscheibe (4b) und einen die innere Kontaktscheibe (4b) in einem Abstand konzentrisch umgebenden äusseren Kontaktring (4a);
(b) der Gatekontakt (7) zwischen der inneren Kontaktscheibe (4b) und dem äusseren Kontaktring (4a) isoliert angeordnet ist; und
(c) die Gatezuführung (8) zwischen der inneren Kontaktscheibe (4b) und dem äusseren Kontaktring (4a) isoliert aus dem Bauelement (1) herausgeführt wird.

10. Bauelement nach Anspruch 9, dadurch gekennzeichnet, dass die Gatezuführung (8) kathodenseitig in einem Anschlussring (20) endet, welcher mittels einer Isoliermasse (20) zwischen innerer Kontaktscheibe (4b) und äusserem Kontaktring (4a) isoliert eingebettet ist.

11. Bauelement nach einem der Ansprüche 1 bis 10, dadurch gekennzeichnet, dass der Gatekontakt (7) als Druckkontakt ausgeführt ist und die Gatezuführung (8) federnd ausgebildet ist.

## Claims

1. Turn-off high-power semiconductor component, in particular in the form of a GTO, comprising a disc-shaped semiconductor substrate (2) which is disposed concentrically in an annular insulating housing (10) between a disc-shaped cathode contact (4), to which pressure can be applied, and a disc-shaped anode contact (5), to which pressure can also be applied, and which is contacted on the cathode-contact side by a gate contact (7, 21) which is of annular design, the cathode contact (4) being connected to one end of the insulating housing (10) via a first lid (11a) and the anode contact (5) to the other end of the insulating housing (10) via a second lid (11b), an outwardly hermetically sealed component (1) being formed, and the gate contact (7) being capable of being fed with a gate current via a gate lead (8) brought to the outside, the gate contact (7) surrounding the cathode contact (4) concentrically at a distance; characterized in that
(a) the gate lead (8) is likewise of annular design and is disposed concentrically with respect to the cathode contact (4); and
(b) the gate lead (8) is electrically insulated from the cathode contact (4) by a single insulator.

2. Component according to Claim 1, characterized in that
(a) the gate lead (8) is brought out of the component (1) between the cathode contact (4) and the insulating housing (10),
(b) the gate lead (8) connects the gate contact (7) directly to the first lid (11a),
(c) and the first lid (11a) is electrically insulated from the cathode contact (4) by an interposed insulating ring (9) which concentrically surrounds the cathode contact (4).

3. Component according to Claim 2, characterized in that the insulating ring (9) is composed of a ceramic.

4. Component according to Claim 2, characterized in that the insulating ring (9) and the cathode contact (4) are joined together by a metallic joining ring (17).

5. Component according to Claim 2, characterized in that the two lids (lla, b) and the gate lead (8) are composed of a metal sheet and the gate lead (8) is joined to the first lid (lla) on the inside of the latter by means of a cold weld.

6. Component according to Claim 5, characterized in that
(a) to provide a gate connection (G) and a cathode connection (K) a strip conductor (15) is provided which comprises an insulating sheet (18) provided with a metallization (16a, b) on both sides;
(b) the strip conductor (15) spans the component (1) on the cathode side, the second metallization (16b) facing the component (1);
(c) the insulating sheet (18) and the second metallization (16b) have been removed from the strip conductor (15) in the region of the cathode contact (4) in such a way that the first metallization (16a) is in direct contact with the cathode contact (4) and forms the cathode connection (K); and
(d) the second metallization (16b) is electrically connected directly to the first lid (11a) and forms the gate connection (G).

7. Component according to Claim 6, characterized in that the insulating sheet (18) of the strip conductor (15) is composed of a polyimide and the two metallizations (16a, b) are composed of Cu, and in that the second metallization (16b) is soldered to the first lid (11a).

8. Component according to Claim 1, characterized in that the insulating housing (10) is subdivided into an upper housing part (10a) and a lower housing part (10b) and the gate lead (8) is brought out of the component (1) between the upper and lower housing part (10a and 10b, respectively).

9. Component according to Claim 1, characterized in that
(a) the cathode contact (4) is subdivided into an inner contact (4b) disc and an outer contact ring (4a) which surrounds the inner contact disc (4b) concentrically at a distance;
(b) the gate contact (7) is disposed in an insulated manner between the inner contact disc (4b) and the outer contact ring (4a); and
(c) the gate lead (8) is brought out of the component (1) in an insulated manner between the inner contact disc (4b) and the outer contact ring (4a).

10. Component according to Claim 9, characterized in that the gate lead (8) terminates on the cathode side in a connecting ring (20) which is embedded in an insulated manner by means of an insulating material (20) [sic] between inner contact disc (4b) and outer contact ring (4a).

11. Component as claimed in any of Claims 1 to 10, characterized in that the gate contact (7) is designed as pressure contact and the gate lead (8) is of resilient design.

## Revendications

1. Dispositif semiconducteur de haute puissance à commande d'extinction, notamment sous la forme d'un GTO, avec un substrat semiconducteur (2) en forme de disque qui est disposé de manière concentrique dans un boîtier isolant (10) de forme annulaire entre un contact de cathode (4) en forme de disque pouvant être exposé à une pression et un contact d'anode (5) en forme de disque pouvant également être exposé à une pression, et est mis en contact sur le côté du contact de cathode par un contact de gâchette (7, 21) de forme annulaire, le contact de cathode (4) étant relié à l'une des extrémités du boîtier isolant (10) par le biais d'un premier couvercle (11a) et le contact d'anode (5) étant relié à l'autre extrémité du boîtier isolant (10) par le biais d'un deuxième couvercle (11b) et formant un dispositif (1) fermé hermétiquement vers l'extérieur, et le contact de gâchette (7) pouvant être exposé à un courant de gâchette par le biais d'une arrivée de gâchette (8) amenée à l'extérieur, le contact de gâchette (7) entourant de manière concentrique le contact de cathode (4) à une certaine distance ;
caractérisé par le fait que
(a) l'arrivée de gâchette (8) est également de forme annulaire et est disposée de manière concentrique par rapport au contact de cathode (8) ;
(b) l'arrivée de gâchette (8) est isolée électriquement du contact de cathode (4) par un isolateur unique.

2. Dispositif selon la revendication 1,
caractérisé par le fait que
(a) l'arrivée de gâchette (8) est amenée à l'extérieur du dispositif (1) entre le contact de cathode (4) et le boîtier isolant (10),
(b) l'arrivée de gâchette (8) relie le contact de gâchette (7) directement au premier couvercle (11a),
(c) le premier couvercle (11a) est isolé électriquement du contact de cathode (4) par un anneau isolant (9) interposé entre les deux et entourant le contact de cathode (4) de manière concentrique.

3. Dispositif selon la revendication 2,
caractérisé par le fait que l'anneau isolant (9) se compose d'une céramique.

4. Dispositif selon la revendication 2,
caractérisé par le fait que l'anneau isolant (9) et la contact de cathode (4) sont reliés électriquement entre eux par le biais d'un anneau de liaison (17) métallique.

5. Dispositif selon la revendication 2,
caractérisé par le fait que les deux couvercles (11a, b) et l'arrivée de gâchette (8) se composent d'une tôle et que l'arrivée de gâchette (8) est reliée au premier couvercle (11a) sur son côté intérieur au moyen d'une soudure à froid.

6. Dispositif selon la revendication 5,
caractérisé par le fait que
(a) un conducteur en bande (9) est prévu pour mettre à disposition une borne de gâchette (G) et une borne de cathode (K), lequel possède sur l'un de ses deux côtés un film isolant (18) muni d'une métallisation (16a, b),
(b) le conducteur en bande (9) recouvre le dispositif (1) du côté cathode, la deuxième métallisation (16b) faisant face au dispositif (1),
(c) le film isolant (9) et la deuxième métallisation (16b) sont retirés du conducteur en bande (9) dans la zone du contact de cathode (4) de façon à ce que la première métallisation (16a) se trouve en contact direct avec le contact de cathode (4) et forme la borne de cathode (K), et
(d) la deuxième métallisation (16b) est directement reliée électriquement au premier couvercle (11a) et forme la borne de.gâchette (G).

7. Dispositif selon la revendication 6,
caractérisé par le fait que le film isolant (18) du conducteur en bande (15) est en polyimide et les deux métallisations (16a, b) sont en cuivre, et que la deuxième métallisation (16b) est brasée avec le premier couvercle (11a).

8. Dispositif selon la revendication 1,
caractérisé par le fait que le boîtier isolant (10) est divisé en une partie supérieure du boîtier (10a) et une partie inférieure du boîtier (10b) et l'arrivée de gâchette (8) est amenée à l'extérieur du dispositif (1) entre les parties supérieure et inférieure du boîtier (10a ou 10b).

9. Dispositif selon la revendication 1,
caractérisé par le fait que
(a) le contact de cathode (4) se compose d'un disque de contact interne (4b) et d'un anneau de contact externe (4a) entourant de manière concentrique le disque de contact interne (4b),
(b) le contact de gâchette (7) est disposé de manière isolée entre le disque de contact interne (4b) et l'anneau de contact externe (4a), et
(c) l'arrivée de gâchette (8) est amenée à l'extérieur du dispositif (1) entre le disque de contact interne (4b) et l'anneau de contact externe (4a).

10. Dispositif selon la revendication 9,
caractérisé par le fait que l'arrivée de gâchette (8) se termine du côté cathode dans un anneau de connexion (20) qui est moulé entre le disque de contact interne (4b) et l'anneau de contact externe (4a) au moyen d'une masse isolante (19).

11. Dispositif selon l'une des revendications 1 à 10, caractérisé par le fait que le contact de gâchette (7) est réalisé sous la forme d'un contact par pression et que l'arrivée de gâchette (8) est élastique.
